# EUROPÄISCHE PATENTSCHRIFT

(11) **EP 1 419 507 B1**
(45) Veröffentlichungstag und Bekanntmachung des Hinweises auf die Patenterteilung: **09.11.2005**
(21) Anmeldenummer: 02782677.5
(22) Anmeldetag: 21.08.2002
(51) Int. Cl.: G11C 29/00

(54) **VERFAHREN UND VORRICHTUNG ZUM PRÜFEN VON HALBLEITERSPEICHEREINRICHTUNGEN**
METHOD AND DEVICE FOR TESTING SEMICONDUCTOR MEMORY DEVICES
PROCEDE ET DISPOSITIF DE TEST DE DISPOSITIFS MEMOIRE A SEMI-CONDUCTEURS

(30) Priorität: 21.08.2001 DE 10140986
(43) Veröffentlichungstag der Anmeldung: 19.05.2004
(73) Patentinhaber: Infineon Technologies AG, 81669 München (DE)
(72) Erfinder: CORDES, Eric, Chapel Hill, NC, 27517 (US); EGGERS, Georg, Erhard, 80335 München (DE); LUEPKE, Jens, 85521 Ottobrunn (DE); STOCKEN, Christian, 82031 Grünwald (DE)
(74) Vertreter: Müller - Hoffmann & Partner
(86) Internationale Anmeldenummer: PCT/DE2002/003058
(87) Internationale Veröffentlichungsnummer: WO 2003/021604

(56) Entgegenhaltungen:
- WO-A-02/39459
- US-B1- 6 195 616

## Beschreibung

Die Erfindung betrifft ein Prüfverfahren für eine Halbleiterspeichereinrichtung mit einem bidirektionalen Datenstrobe-Anschluss für ein Datenstrobe-Signal und mit mindestens einem Daten-Anschluss für ein Datensignal an einer Prüfapparatur, die mindestens Datenstrobe- und Datensignale zu erzeugen, sowie Datensignale zu übertragen und zu bewerten vermag. Außerdem bezieht sich die Erfindung auf eine Vorrichtung zum Prüfen solcher Halbleiterspeichereinrichtungen.

Die Prüfung von Halbleiterspeichereinrichtungen erfolgt an Prüfapparaturen mit in der Regel mehreren identischen Prüfköpfen, die ihrerseits mehrere Prüfplätze für zu prüfende Halbleiterspeichereinrichtungen (im Folgenden auch Prüflinge) aufweisen. Jeder Prüfplatz verfügt u.a. über Ausgänge (im Folgenden Treiber), sowie über bidirektionale Ein- und Ausgänge (im Folgenden I/O-Ports) zur Ausgabe und zum Empfang von Datensignalen.
Die Anzahl der I/O-Ports pro Prüfplatz ist beschränkt und orientiert sich bei Prüfapparaturen für herkömmliche Halbleiterspeichereinrichtungen an der Anzahl der DatenAnschlüsse der Halbleiterspeichereinrichtungen. Sie beträgt deshalb in der Regel ein Vielfaches von Acht oder Zwölf. Bei maximaler Bestückung eines Prüfkopfes werden regelmäßig alle I/O-Ports eines Prüfkopfes benutzt.

Im Verlauf der Prüfung übertragen die von der Prüfapparatur über deren I/O-Ports ausgegebenen Datensignale Daten zum Prüfling, bzw. übertragen die vom Prüfling über die DatenAnschlüsse ausgegebenen Datensignale Daten zur Prüfapparatur. Dabei erfolgt die Übertragung und die Bewertung der von der Prüfapparatur empfangenen Datensignale immer synchronisiert zu einem internen Takt der Prüfapparatur.

Halbleiterspeichereinrichtungen neueren Typs können zusätzlich zu den bidirektionalen Daten-Anschlüssen noch mindestens einen weiteren bidirektionalen Datenstrobe-Anschluss für ein parallel zu den Datensignalen betriebenes Datenstrobe-Signal aufweisen. Dieses Datenstrobe-Signal wird beim Auslesen von Daten aus der Halbleiterspeichereinrichtung von der Halbleiterspeichereinrichtung und beim Schreiben von Daten in die Halbleiterspeichereinrichtung von einer Speichersteuereinrichtung (im Folgenden memory controller) ausgegeben (im Folgenden auch: getrieben).

Ein solches Signal kann dem Steuern oder Synchronisieren der Schreib- und Lesevorgänge (im Folgenden des Datentransfers) dienen.

Beim Prüfen solcher Halbleiterspeichereinrichtungen neueren Typs, die einen dem Synchronisieren oder Steuern des Datentransfers dienenden bidirektionalen Datenstrobe-Anschluss aufweisen, an herkömmlichen Prüfapparaturen, also solchen, die zur Prüfung herkömmlicher Halbleiterspeichereinrichtungen konzipiert sind, ergeben sich Probleme hinsichtlich der Anzahl der verfügbaren I/O-Ports pro Prüfplatz und des Prüfens der Zeitbedingungen (im Folgenden des Timings) des Datenstrobe-Signals.

Letzteres ergibt sich daraus, dass die Prüfapparatur beim Auslesen von Daten aus dem Prüfling den Lesevorgang anregt und die an den I/O-Ports anliegenden Datensignale synchronisiert zu dieser Anregung bewertet, also synchronisiert zu einem internen Takt der Prüfapparatur selbst. Weist der Prüfling aber ein Datenstrobe-Signal der oben erwähnten Art auf, dann muss die Bewertung der Datensignale bei vollständiger bzw. applikationsnaher Prüfung synchronisiert zum Datenstrobe-Signal erfolgen, das zwar abhängig vom Taktsignal sein kann, aber keineswegs sein muss. Gerade dazu sind aber für herkömmliche Halbleiterspeichereinrichtungen konzipierte Prüfapparaturen nicht in der Lage, weil dafür bisher kein Erfordernis bestand.

Das zweite Problem betrifft die Resourcen der Prüfapparatur. Die maximale Anzahl der möglichen Prüfplätze (und damit auch Prüflinge) pro Prüfkopf ergibt sich in der Regel direkt aus der Gesamtzahl der I/O-Ports auf einem Prüfkopf und der Anzahl der bidirektionalen Anschlüsse auf einem Prüfling. Bei Halbleiterspeichereinrichtungen herkömmlichen Typs sind regelmäßig nur die Datenanschlüsse bidirektional, deren Anzahl entsprechend der üblichen Datenbus-Breite in der Regel ein Vielfaches von Acht oder Zwölf ist. Entsprechend ist auch die Gesamtzahl der I/O-Ports ein Vielfaches von Acht oder Zwölf. Weiter sind die I/O-Ports elektrisch, mechanisch und programmtechnisch in zur Datenbusbreite kompatible Einheiten organisiert und in ihrer Zuordenbarkeit zu den Prüfplätzen beschränkt.

Ein zusätzlicher bidirektionaler Anschluss auf der Halbleiterspeichereinrichtung reduziert die Anzahl der Prüflinge, die pro Prüfdurchgang an der Prüfapparatur geprüft werden können, da der zusätzlich benötigte I/O-Port für das Datenstrobe-Signal nur von einem zweiten Prüfplatz zur Verfügung gestellt werden kann. Da der zweite Prüfplatz dann nicht nur für die Aufnahme eines weiteren Prüflings blokkiert ist, sondern darüberhinaus durch die Organisation der Prüfapparatur auch ungeeignet ist, I/O-Ports für andere Prüflinge auf dem gemeinsamen Prüfkopf zur Verfügung zu stellen, halbiert sich letztendlich die Anzahl der Prüflinge pro Prüfdurchgang.

Aufgabe der Erfindung ist es daher, ein Prüfverfahren zur Verfügung zu stellen, bei der das Timing des zusätzlichen Datenstrobe-Signals geprüft und der Prüfdurchsatz von Halbleiterspeichereinrichtungen neuen Typs an Prüfapparaturen für Halbleiterspeichereinrichtungen herkömmlichen Typs erhöht wird, sowie eine Vorrichtung zu dessen Realisierung zu schaffen.

Diese Aufgabe wird erfindungsgemäß durch ein gattungsgemäßes Prüfverfahren nach Anspruch 1, sowie eine gattungsgemäße Vorrichtung nach Anspruch 10 gelöst. Vorteilhafte Weiterbildungen sind in den jeweils nachgeordneten Unteransprüchen angegeben.

Demnach werden im Verlauf der Prüfung einer ersten Halbleiterspeichereinrichtung unter Verwendung der Daten- und des Datenstrobe-Signals Daten von der ersten Halbleiterspeichereinrichtung zu einer gleichartigen zweiten Halbleiterspeichereinrichtung übertragen und nach einem Auslesen aus der zweiten Halbleiterspeichereinrichtung von der Prüfapparatur bewertet.

Die Bewertung des Datenstrobe-Signals der ersten Halbleiterspeichereinrichtung (des Prüflings) wird also der zweiten Halbleiterspeichereinrichtung (der Referenz) überlassen. Dies ist möglich, da jede Halbleiterspeichereinrichtung über die internen Elemente verfügt, die nötig sind, um die Daten- und das Datenstrobe-Signal, sowie deren korrekte zeitliche Abfolge zueinander zu bewerten.

Da das Datenstrobe-Signal von der Prüfapparatur nur mehr getrieben, aber nicht mehr bewertet wird, muss die Datenstrobe-Leitung nicht mehr an einem I/O-Port, sondern kann vielmehr an einen einfachen Treiber der Prüfapparatur angeschlossen werden. Damit können pro Prüfkopf und pro Prüfdurchgang genausoviel Halbleiterspeichereinrichtungen neuen Typs geprüft werden wie solche herkömmlichen Typs.

Die zu prüfende Halbleiterspeichereinrichtung neuen Typs (der Prüfling) wird an der Prüfapparatur zur Prüfung von Halbleiterspeichereinrichtungen herkömmlichen Typs an einem Prüfplatz wie eine solche sonst gleichartige Halbleiterspeichereinrichtung herkömmlichen Typs angeschlossen, wobei der bidirektionale Datenstrobe-Anschluss des Prüflings direkt oder über eine von der Prüfapparatur gesteuerte Schalteinrichtung mit einem Treiber des selben Prüfplatzes verbunden wird. Danach wird der Prüfling einem dem für Halbleiterspeichereinrichtungen herkömmlichen Typs entsprechenden Prüfablauf unterworfen, währenddem die Prüfapparatur das Datenstrobe-Signal über den Treiber beim Schreiben von Daten in geeigneter Weise erzeugt.

Nach diesem erstem Teil des Prüfablaufs ist der Prüfling, abgesehen von der Bewertung des Datenstrobe-Signals beim Auslesen von Daten aus dem Prüfling, komplett geprüft.

Um das Datenstrobe-Signal beim Auslesen von Daten aus dem Prüfling hinsichtlich gültiger Signalpegel und zeitlicher Lage zu den Datensignalen zu prüfen, wird wie folgt verfahren:

Der Prüfling wird an mindestens einer Testdaten-Adresse mit Testdaten beschrieben, die Referenz an der Testdaten-Adresse mit von den Testdaten unterscheidbaren Referenzdaten. Danach werden die Daten- und die Datenstrobe-Anschlüsse des Prüflings und der Referenz mittels einer von der Prüfapparatur gesteuerten Schaltvorrichtung von der Prüfapparatur getrennt und stattdessen miteinander verbunden. In der Folge initiiert die Prüfapparatur zunächst einen Lesevorgang am Prüfling und im geeigneten, durch die Timing-Spezifikationen der Halbleiterspeichereinrichtung vorgegebenen zeitlichen Abstand dazu einen Schreibvorgang an der Referenz, also einen Datentransfer der Testdaten vom Prüfling zur Referenz an der Testdaten-Adresse der Test- bzw. Referenzdaten. Nach dem Datentransfer werden die Datenanschlüsse der Referenz vom Prüfling getrennt und an die Prüfapparatur angeschlossen. Danach liest die Prüfapparatur die Daten an der Testdaten-Adresse aus.

Aus der Referenz können nur dann die Testdaten ausgelesen werden, wenn während des Datentransfers vom Prüfling zur Referenz vom Prüfling ein korrektes Datenstrobe-Signal getrieben wurde. Andernfalls werden aus der Referenz die unveränderten Referenzdaten ausgelesen.

Das Umschalten der Datenstrobe- und Datenleitungen erfolgt über von der Prüfapparatur gesteuerte Schalteinrichtungen (Relais,FETs).

Als Referenz kann für jeden Prüfling jeweils eine in der o.g. Schaltvorrichtung enthaltene, bereits geprüfte Halbleiterspeichereinrichtung gleichen Typs Verwendung finden. In diesem Fall ist die Referenz Bestandteil der Schaltvorrichtung und bleibt es, während immer neue Prüflinge am Prüfplatz zur Prüfung bestückt werden. Zur Ansteuerung der Referenz werden überzählige Treiber des Prüfplatzes verwendet, während die I/O-Ports des Prüfplatzes wechselweise an den Prüfling oder an die Referenz geschalten werden.

In bevorzugter Weise wird aber als Referenz ein zweiter Prüfling auf der selben Prüfapparatur, besonders bevorzugt auf dem selben Prüfkopf benutzt. Bei einer Bestückung des Prüfkopfes mit einer geraden Anzahl von Prüflingen werden die Prüflinge in zwei Gruppen PG und RG geteilt, wobei zunächst die Prüflinge der Gruppe PG mit den Prüflingen der Gruppe RG als Referenz geprüft werden und anschließend die Prüflinge der Gruppe RG mit denen der Gruppe PG als Referenz.

Das erfindungsgemäße Verfahren ist in besonders bevorzugter Weise auf Halbleiterspeichereinrichtungen mit Double-Data-Rate-Interface (DDR-IF) gemäß JEDEC-Standard anzuwenden.

Im Gegensatz zu herkömmlichen synchronen Halbleiterspeichereinrichtungen, bei denen Schreib- und Lesezugriffe jeweils an der steigenden oder fallenden Flanke eines Taktsignals stattfinden, ist bei Halbleiterspeichereinrichtungen mit DDR-IF sowohl bei der steigenden, als auch bei der fallenden Flanke des Taktsignals ein Datentransfer möglich, womit sich bei gleicher Taktfrequenz eine annähernde Verdopplung der möglichen Datentransfer-Rate ergibt. Zur Synchronisation des eigentlichen Datentransfers zwischen Halbleitereinrichtungen mit DDR-IF wird jedoch nicht das Taktsignal (CLK), sondern ein daraus abgeleitetes Signal "Data Query Strobe" (DQS) herangezogen. DQS entspricht einem Datenstrobe-Signal, das während des Lesens von Daten aus einer Halbleiterspeichereinrichtung wie die Datensignale (DQ) von der Halbleiterspeichereinrichtung und beim Schreiben von Daten in die Halbleiterspeichereinrichtung wie die Datensignale (DQ) von einem memory controller erzeugt wird.

Beim Schreiben von Daten in die Halbleiterspeichereinrichtung mit DDR-IF wird DQS so gesteuert, daß jede Flanke von DQS die Mitte eines übertragenen Datenbits an DQ anzeigt. Die Halbleiterspeichereinrichtung mit DDR-IF übernehmen die Daten auf DQ jeweils zum Zeitpunkt einer Flanke an DQS.

Beim Lesen aus der DDR-IF Halbleiterspeichereinrichtung wird DQS flankensynchron zu den Daten DQ erzeugt. Der memory controller erwartet die Daten an den Datenleitungen nach jeder Flanke an DQS.

Daraus ergibt sich, dass die Laufzeiten von DQ und DQS beim Datentransfer zwischen Prüfling und Referenz über Verzögerungseinrichtungen eindeutig definiert werden müssen, um einen korrekten Datentransfer überhaupt erst zu ermöglichen oder das Timing zwischen DQ und DQS bezüglich eines ausreichenden Vorhaltes zu prüfen.

Als Verzögerungseinrichtungen kommen Monoflops, Eimerketten-Schaltungen oder Verzögerungsleitungen in Betracht.

Die Verbindungsleitung zwischen dem DQS-Anschluss des Prüflings und dem der Referenz kann weitere Einrichtungen enthalten, die dazu dienen, das DQS-Signal unter verschärften Bedingungen zu prüfen, etwa durch Absenken des Signalpegels von DQS.

Ebenso ist es möglich, für die Anwendung des erfindungsgemäßen Prüfverfahrens die Halbleiterspeichereinrichtungen mit geeigneten Schaltungen und Funktionen aufzurüsten.

In einem Testmode der Halbleiterspeichereinrichtung kann etwa das Zeitfenster für Schreibzugriffe in der Referenz reduziert und damit die Prüfschärfe für das Timing der vom Prüfling ausgegebenen Datenstrobe- und Datensignale verbessert werden.

Im gleichen Testmode können des Weiteren in den Halbleiterspeichereinrichtungen selbst realisierten Verzögerungseinrichtungen in die betroffenen Signalleitungen geschalten werden.

Im Folgenden werden die Verzögerungseinrichtungen durch Verzögerungsleitungen realisiert, ohne dass dadurch die Realisierung des erfindungsgemäßen Verfahrens und der erfindungsgemäßen Anordnung auf diese Ausführungsform beschränkt wird.

In einer besonders bevorzugten Ausführungweise des erfindungsgemäßen Verfahrens wird DQS lediglich applikationsnah, ohne weitere Vorhalte, geprüft. Dazu wird DQS zwischen dem Prüfling und der Referenz um 1/4 der Periodendauer von CLK bzw. DQS (t_{clk}/4) gegenüber dem DQS am Ausgang des Prüflings verzögert. Bei dieser Ausführungsform des Verfahrens ist DQS an der Referenz nicht mehr flankensynchron zu CLK. Die Länge einer einfachen Verzögerungsleitung beträgt dabei etwa 0,5 m.

In einer zweiten Ausführung wird DQS um eine ganze Periodendauer von CLK (t_{clk}) verzögert. Damit bleibt DQS flankensynchron zu CLK. Da DQS um 1/4 t_{clk} den Daten vorlaufen muss, werden alle DQ um 3/4 t_{clk} verzögert. Nachteilig gegenüber der ersten Ausführungsweise ist, dass alle DQ mit Verzögerungsleitungen zu versehen sind, sowie die dazu benötigten Längen von etwa 1,5 m für DQ und über 2 m für DQS.

In einer dritten Ausführungsform wird an der Referenz statt CLK das invertierte Taktsignal INVCLK angeschlossen, womit DQS an der Referenz nur um 1/2 t_{clk} und DQ entsprechend nur mehr um 1/4 t_{clk} verzögert werden müssen. Gegenüber der vorangegangenen Ausführungsform verringert sich zwar bei der Realisierung der Verzögerungseinrichtungen durch Verzögerungsleitungen deren Länge, doch steigt der Aufwand durch die nicht mehr einheitliche Taktsignal-Steuerung auf dem Prüfkopf.

Das DDR-Interface ist heute insbesondere auf DRAMs üblich.

In bevorzugter Weise geeignet ist eine Vorrichtung der erfindungsgemäßen Art für alle zur Prüfung von Halbleiterspeichereinrichtungen ohne Datenstrobe-Anschluss konzipierten Prüfapparaturen.

Nachfolgend wird die Erfindung anhand einer beispielhaften Ausführungsform in Zusammenhang mit den Zeichnungen näher erläutert. Es zeigen:
- Fig. 1: Eine schematische Darstellung der erfindungsgemäßen Vorrichtung in einer besonders bevorzugten Ausführungsform.
- Fig. 2: ein schematisches Zeitdiagramm für die Signale an Prüfling und Referenz während des Datentransfers.

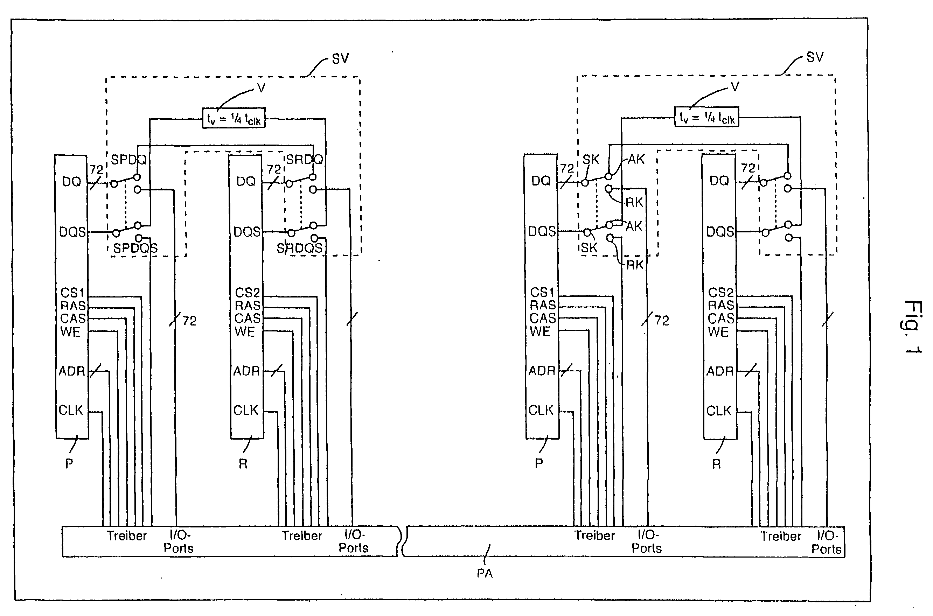

Fig. 1 zeigt eine Prüfapparatur PA und zwei Paare von zu prüfenden Halbleiterspeichereinrichtungen, aus jeweils einem Prüfling P und einer Referenz R. Die Beschränkung auf zwei Paare dient dabei der Übersichtlichkeit der Darstellung. Prüfling und Referenz sind in diesem Fall als DDR-DRAMs gezeichnet. Die Steuereingänge der DDR-DRAMs, von denen hier CS, RAS, CAS, WE, ADR und CLK dargestellt sind, werden an die Treiber der PA angeschlossen, die hier 72 DQ-Anschlüsse sowie der DQS-Anschluss an eine Schaltvorrichtung SV.

Die Schaltvorrichtung SV besteht aus Schalteinrichtungen, in diesem Fall Relais mit Ruhe-, Arbeits- und Schaltkontakt (RK, AK, SK), wobei jeder DQ- und der DQS-Anschluss, jeweils von Prüfling und von Referenz, an die Schaltkontakte SK der Schalteinrichtungen SPDQ, SRDQ, SPDQS bzw. SRDQS angeschlossen sind. Die Ruhekontakte RK der Schalteinrichtungen SPDQ und SRDQ sind mit I/O-Ports der Prüfapparatur PA verbunden, die Ruhekontakte der Schalteinrichtungen SPDQS und SRDQS mit jeweils einem Treiber der Prüfapparatur PA. Die Kontakte der Relais sind im Arbeitszustand gezeichnet. Auf die Darstellung der Relaisansteuerung wurde aus Gründen der Übersichtlichkeit verzichtet.

Die Arbeitskontakte der Schalteinrichtungen SPDQ sind mit denen der Schalteinrichtungen SRDQ, der Arbeitskontakt der Schalteinrichtung SPDQS über eine Verzögerungsleitung mit der Verzögerungszeit 1/4 t_{Clk} mit dem der Schalteinrichtung SRDQS verbunden.

Während der Prüfung werden die Prüflinge P und die Referenzen R zunächst mit den Schalteinrichtungen SPDQS, SRDQS, SPDQ und SRDQ in Ruhestellung in ihrer Funtionalität so weit wie möglich in gleicher Weise wie herkömmliche DRAMs geprüft. Dies kann durchaus auch das Beschreiben und Auslesen der DDR-DRAMs umfassen. Lediglich die Bewertung von DQS beim Auslesen der Daten aus den DDR-DRAMs ist zunächst nicht möglich.

Dazu werden die Prüflinge P mit einem Testmuster und die Referenzen R mit einem davon unterscheidbaren Referenzmuster beschrieben. Anschließend werden alle Schalteinrichtungen in der Schaltvorrichtung SV umgeschalten. Damit werden DQS und DQ von der Prüfapparatur getrennt und stattdessen jeweils entsprechende DQ- und die DQS-Anschlüsse jeweils eines Prüflings P und einer Referenz R miteinander verbunden, wobei DQS zwischen Prüfling und Referenz um 1/4 t_{Clk} verzögert wird. Danach wird auf den Prüflingen ein Lesezyklus und in geeignetem zeitlichen Abstand dazu auf den Referenzen R ein Schreibzyklus angestoßen, worauf in der Folge das Testmuster von den Prüflingen P zu den Referenzen R übertragen wird. Danach werden die Verbindungen zwischen den Prüflingen und den Referenzen wieder getrennt und stattdessen deren DQS- und DQ-Anschlüsse an die Prüfapparatur angeschlossen.

Zum Schluss liest die Prüfapparatur die Daten von den Referenzen aus. Da diese zum Einlesen von Daten ein gültiges DQS erwarten, ist aus diesen nur dann das Testmuster und nicht das Referenzmuster auszulesen, wenn der dazugehörige Prüfling P während der Datenübertragung ein gültiges Signal an DQS ausgegeben hat.

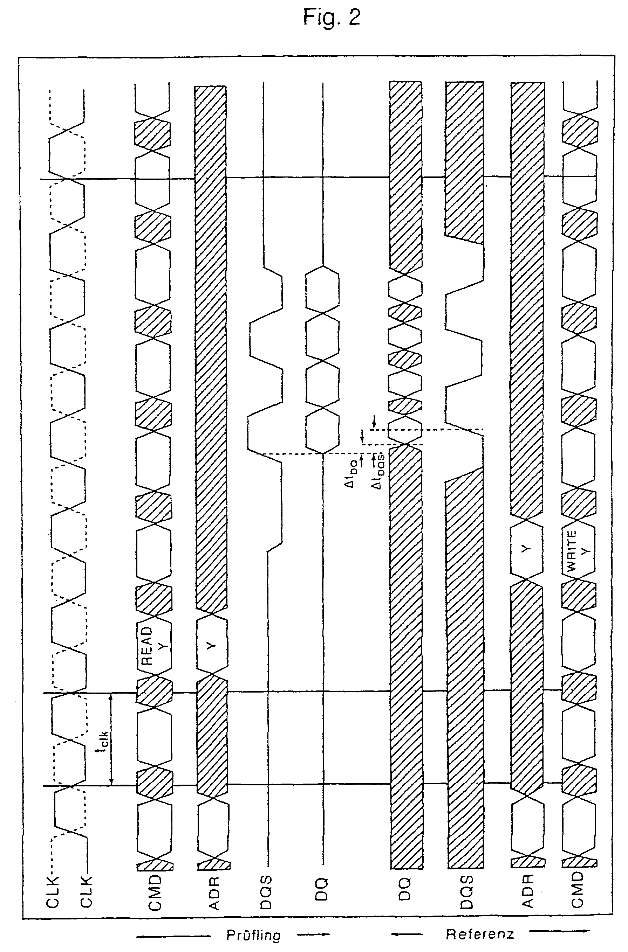

Fig. 2 zeigt den Ablauf einer Datenübertragung vom Prüfling zur Referenz durch die Darstellung der Zeitverläufe der gemeinsamen Taktsignale (CLK,INVCLK), der Steuer-, Adress- und DQ-Signale (CMS, ADR, DQ) und des DQS-Signals (DQS) jeweils für den Prüfling P oben und für die Referenz R unten. Mit einem Steuerbefehl READ Y auf CMD wird das Auslesen der Daten von einer Adresse Y auf ADR aus dem Prüfling angeregt, mit einem an der nächsten steigenden Flanke an CLK folgenden Steuerbefehl WRITE Y ein Schreibvorgang in der Referenz. Der Zeitversatz Δt_{DQS} zwischen den DQS am Prüfling und der Referenz ergibt sich hier zu etwa 1/4 t_{Clk}. Ein geringer Zeitversatz Δt_{DQ} zwischen den DQ an Prüfling und Referenz ergibt sich aus einer Mindestlänge der Verbindung zwischen den DQ-Anschlüssen des Prüflings und der Referenz.

### Bezugszeichenliste

- P: Prüfling
- R: Referenz
- PA: Prüfapparatur
- SV: Schaltvorrichtung
- SPDQS: Schalteinrichtung zu DQS am Prüfling
- SRDQS: Schalteinrichtung zu DQS an der Referenz
- SPDQ: Schalteinrichtungen zu DQ am Prüfling
- SRDQ: Schalteinrichtungen zu DQ an der Referenz
- RK: Ruhekontakt
- AK: Arbeitskontakt
- SK: Schaltkontakt
- V: Verzögerungsleitung
- t_{Clk}: Periodendauer des Taktsignals CLK
- t_{V}: Verzögerungszeit der Verzögerungsleitung
- Δt_{DQ}: Zeitversatz von DQ an der Referenz
- Δt_{DQS}: Zeitversatz von DQS an der Referenz
- CMD: Signale an den Steueranschlüssen
- ADR: Signale an den Adressanschlüssen
- Y: Column-Adress der Testdaten
- DQ: Signal DQ
- DQS: Signal DQS
- READ Y: Steuersignal zum Auslesen (des Prüflings)
- WRITE Y: Steuersignal zum Beschreiben (der Referenz)

## Patentansprüche

1. Prüfverfahren für eine erste Halbleiterspeichereinrichtung (P) mit
- einem bidirektionalen Datenstrobe-Anschluss für ein Datenstrobe-Signal (DQS) und
- mindestens einem bidirektionalen Daten-Anschluss für Datensignale (DQ),
an einer Prüfapparatur (PA), die mindestens Datenstrobe- und Datensignale zu erzeugen und Datensignale zu übertragen und zu bewerten vermag,
**dadurch gekennzeichnet,**
**dass** im Verlauf der Prüfung unter der Verwendung der Datenstrobe- und Datensignale Daten von der ersten Halbleiterspeichereinrichtung (P) zu einer gleichartigen zweiten Halbleiterspeichereinrichtung (R) übertragen und nach einem Auslesen aus der zweiten Halbleiterspeichereinrichtung (R) von der Prüfapparatur (PA) bewertet werden.

2. Verfahren nach Anspruch 1,
**dadurch gekennzeichnet,**
**dass** anschließend die Prüfung wiederholt wird, wobei die zunächst erste Halbleiterspeichereinrichtung an Stelle der zweiten und die zunächst zweite an Stelle der ersten tritt.

3. Verfahren nach einem der Ansprüche 1 oder 2,
**dadurch gekennzeichnet,**
**dass** die Datensignale DQ-Signale und das Datenstrobe-Signal ein DQS-Signal eines DDR-Interfaces gemäß JEDEC-Standard sind.

4. Verfahren nach einem der Ansprüche 1 bis 3,
**dadurch gekennzeichnet,**
**dass** die zweite Halbleiterspeichereinrichtungen während der Datenübertragung von der ersten zur zweiten Halbleiterspeichereinrichtung in einem Testmode betrieben wird und im Testmode das erlaubte Zeitfenster für Schreibzugriffe verkleinert ist.

5. Verfahren nach einem der Ansprüche 1 bis 4,
**dadurch gekennzeichnet,**
**dass** einer der beiden Halbleiterspeichereinrichtungen während der Datenübertragung von der ersten zur zweiten Halbleiterspeichereinrichtung in einem Testmode betrieben wird und im Testmode das Datenstrobe-Signal verzögert.

6. Verfahren nach einem der Ansprüche 1 bis 5
**dadurch gekennzeichnet,**
**dass** in der Verbindung zwischen den Datenstrobe-Anschlüssen der ersten und der zweiten Halbleiterspeichereinrichtung eine Verzögerungseinrichtung (V) einer ersten Art vorgesehen wird, das das Datenstrobe-Signal um 1/4 der Dauer einer Periode des Datenstrobe-Signals verzögert.

7. Verfahren nach einem der Ansprüche 1 bis 5,
**dadurch gekennzeichnet,**
**dass** in der Verbindung zwischen den Datenstrobe-Anschlüssen der ersten und der zweiten Halbleiterspeichereinrichtung eine Verzögerungseinrichtung einer zweiten Art vorgesehen wird und die Verzögerungseinrichtung das Datenstrobe-Signal um die Dauer einer ganzen Periode des Datenstrobe-Signals verzögert und
**dass** in den Verbindungen zwischen korrespondierenden Daten-Anschlüssen der ersten und der zweiten Halbleiterspeichereinrichtung jeweils Verzögerungseinrichtungen einer dritten Art vorgesehen werden, die das entsprechende Datensignal um 3/4 der Periodendauer des Datenstrobe-Signals verzögern.

8. Verfahren nach einem der Ansprüche 1 bis 5,
**dadurch gekennzeichnet,**
**dass** in der Verbindung zwischen den Datenstrobe-Anschlüssen der ersten und der zweiten Halbleiterspeichereinrichtung eine Verzögerungseinrichtung einer vierten Art vorgesehen wird und diese Verzögerungseinrichtung das Datenstrobe-Signal um die Hälfte der Dauer einer Periode des Datenstrobe-Signals verzögert,
**dass** die Verbindungen zwischen korrespondierenden Daten-Anschlüssen der ersten und der zweiten Halbleiterspeichereinrichtung jeweils Verzögerungseinrichtungen der ersten Art aufweisen, die das entsprechende Datensignal um 1/4 der Periodendauer des Datenstrobe-Signals verzögern und
**dass** die beiden Halbleiterspeichereinrichtungen an zueinander invertierten Taktsignalen angeschlossen werden.

9. Verfahren nach einem der Ansprüche 1 bis 8,
**dadurch gekennzeichnet,**
**dass** als Halbleiterspeichereinrichtungen DDR-DRAMs oder solche, die DDR-DRAMs enthalten, vorgesehen werden.

10. Vorrichtung mit einer ersten Halbleiterspeichereinrichtung (P), mit
- einem bidirektionalen Datenstrobe-Anschluss für ein Datenstrobe-Signal (DQS) und
- mindestens einem bidirektionalen Daten-Anschluss für Datensignale (DQ),
an einer Prüfapparatur (PA), die mindestens Datenstrobe- und Datensignale zu erzeugen und Datensignale zu übertragen und zu bewerten vermag,
**gekennzeichnet durch**
eine Schaltvorrichtung (SV), die die Datenstrobe- und DatenAnschlüsse der ersten und einer zweiten Halbleiterspeichereinrichtung (R) jeweils entweder mit der Prüfapparatur (PA) oder über jeweils eine Verbindung mit dem korrespondierenden Anschluss der jeweils anderen Halbleiterspeichereinrichtung verbindet.

11. Vorrichtung nach Anspruch 10,
**gekennzeichnet durch**
ein auf der Halbleiterspeichereinrichtung befindliches DDR-Interface gemäß JEDEC-Standard.

12. Vorrichtung nach einem der Ansprüche 10 oder 11,
**gekennzeichnet durch**
eine Verzögerungseinrichtung (V) einer ersten Art in der Verbindung zwischen den Datenstrobe-Anschlüssen der ersten und der zweiten Halbleiterspeichereinrichtung, die das Datenstrobe-Signal um 1/4 der Dauer einer Periode des Datenstrobe-Signals verzögert.

13. Vorrichtung nach einem der Ansprüche 10 oder 11,
**gekennzeichnet durch**
eine Verzögerungseinrichtung einer zweiten Art in der Verbindung zwischen den Datenstrobe-Anschlüssen der ersten und der zweiten Halbleiterspeichereinrichtung, die das Datenstrobe-Signal um die Dauer einer ganzen Periode des Datenstrobe-Signals verzögert und
Verzögerungseinrichtungen einer dritten Art in den Verbindungen zwischen korrespondierenden Daten-Anschlüssen der ersten und der zweiten Halbleiterspeichereinrichtung, die das entsprechende Datensignal um 3/4 der Periodendauer des Datenstrobe-Signals verzögern.

14. Vorrichtung nach einem der Ansprüche 10 oder 11,
**gekennzeichnet durch**
eine Verzögerungseinrichtung einer vierten Art in der Verbindung zwischen den Datenstrobe-Anschlüssen der ersten und der zweiten Halbleiterspeichereinrichtung, die das Datenstrobe-Signal um die Hälfte der Dauer einer Periode des Datenstrobe-Signals verzögert und
Verzögerungseinrichtungen der ersten Art in den Verbindungen zwischen korrespondierenden Daten-Anschlüssen der ersten und der zweiten Halbleiterspeichereinrichtung, die das entsprechende Daten-Signal um 1/4 der Periodendauer des Datenstrobe-Signals verzögern.

15. Vorrichtung nach einem der Ansprüche 10 bis 14,
**gekennzeichnet durch**
DDR-DRAMs als Halbleiterspeichereinrichtungen oder als Teil einer Halbleiterspeichereinrichtung.

16. Vorrichtung nach einem der Ansprüche 10 bis 15,
**gekennzeichnet durch**
eine für herkömmliche Halbleiterspeichereinrichtungen ohne Datenstrobe-Anschluss konzipierte Prüfapparatur (PA).

## Claims

1. Test method for a first semiconductor memory device (P) having
- a bidirectional data strobe terminal for a data strobe signal (DQS) and
- at least one bidirectional data terminal for data signals (DQ),
at a test apparatus (PA), which can at least generate data strobe and data signals and transfer and evaluate data signals,
**characterized**
**in that**, in the course of the test using the data strobe and data signals, data are transferred from the first semiconductor memory device (P) to a second semiconductor memory device (R) of identical type and are evaluated after a read-out from the second semiconductor memory device (R) by the test apparatus (PA).

2. Method according to Claim 1,
**characterized**
**in that** the test is subsequently repeated, the initially first semiconductor memory device replacing the second device and the initially second semiconductor memory device replacing the first device.

3. Method according to either of Claims 1 and 2,
**characterized**
**in that** the data signals are DQ signals and the data strobe signal is a DQS signal of a DDR interface in accordance with a JEDEC standard.

4. Method according to one of Claims 1 to 3,
**characterized**
**in that** the second semiconductor memory device is operated in a test mode during the data transfer from the first to the second semiconductor memory device and the permitted time window for write accesses is reduced in the test mode.

5. Method according to one of Claims 1 to 4,
**characterized**
**in that** one of the two semiconductor memory devices is operated in a test mode during the data transfer from the first to the second semiconductor memory device and delays the data strobe signal in the test mode.

6. Method according to one of Claims 1 to 5,
**characterized**
**in that** a delay device (V) of a first type, which delays the data strobe signal by 1/4 of the duration of a period of the data strobe signal is provided in the connection between the data strobe terminals of the first and second semiconductor memory devices.

7. Method according to one of Claims 1 to 5,
**characterized**
**in that** a delay device of a second type is provided in the connection between the data strobe terminals of the first and second semiconductor memory devices and the delay device delays the data strobe signal by the duration of a whole period of the data strobe signal, and
**in that** delay devices of a third type, which delay the corresponding data signal by 3/4 of the period duration of the data strobe signal, are respectively provided in the connections between corresponding data terminals of the first and second semiconductor memory devices.

8. Method according to one of Claims 1 to 5,
**characterized**
**in that** a delay device of a fourth type is provided in the connection between the data strobe terminals of the first and second semiconductor memory devices and said delay device delays the data strobe signal by half the duration of a period of the data strobe signal,
**in that** the connections between corresponding data terminals of the first and second semiconductor memory devices respectively have delay devices of the first type which delay the corresponding data signal by 1/4 of the period duration of the data strobe signal, and
**in that** the two semiconductor memory devices are connected to mutually inverted clock signals.

9. Method according to one of Claims 1 to 8,
**characterized**
**in that** the semiconductor memory devices provided are DDR-DRAMs or ones which contain DDR-DRAMs.

10. Device for a first semiconductor memory device (P) having
- a bidirectional data strobe terminal for a data strobe signal (DQS) and
- at least one bidirectional data terminal for data signals (DQ),
at a test apparatus (PA), which can at least generate data strobe and data signals and transfer and evaluate data signals,
**characterized by**
a switching device (SV), which connects the data strobe and data terminals of the first and a second semiconductor memory device (R) respectively either to the test apparatus (PA) or via a respective connection to the corresponding terminal of the respective other semiconductor memory device.

11. Device according to Claim 10,
**characterized by**
a DDR interface in accordance with a JEDEC standard situated on the semiconductor memory device.

12. Device according to either of Claims 10 and 11,
**characterized by**
a delay device (V) of a first type in the connection between the data strobe terminals of the first and second semiconductor memory devices, which delays the data strobe signal by 1/4 of the duration of a period of the data strobe signal.

13. Device according to either of Claims 10 and 11,
**characterized by**
a delay device of a second type in the connection between the data strobe terminals of the first and second semiconductor memory devices, which delays the data strobe signal by the duration of a whole period of the data strobe signal, and
delay devices of a third type in the connections between corresponding data terminals of the first and second semiconductor memory devices, which delay the corresponding data signal by 3/4 of the period duration of the data strobe signal.

14. Device according to either of Claims 10 and 11,
**characterized by**
a delay device of a fourth type in the connection between the data strobe terminals of the first and second semiconductor memory devices, which delays the data strobe signal by half the duration of a period of the data strobe signal, and
delay devices of the first type in the connections between corresponding data terminals of the first and second semiconductor memory devices, which delay the corresponding data signal by 1/4 of the period duration of the data strobe signal.

15. Device according to one of Claims 10 to 14,
**characterized by**
DDR-DRAMs as semiconductor memory devices or as part of a semiconductor memory device.

16. Device according to one of Claims 10 to 15,
**characterized by**
a test apparatus (PA) designed for conventional semiconductor memory devices without a data strobe terminal.

## Revendications

1. Procédé de contrôle d'un premier dispositif (P) de mémoire à semi-conducteurs comprenant
- une borne - activation de données bidirectionnelle pour un signal activation de données (DQS) et
- au moins une borne - données bidirectionnelle pour des signaux (DQ) de données
sur un dispositif (PA) de contrôle, qui peut produire au moins des signaux d'activation de données et des signaux de données et transmettre et évaluer des signaux de données,
**caractérisé en ce qu'**au cours du contrôle, on transmet, en utilisant les signaux d'activation de données et les signaux de données, des données du premier dispositif (P) de mémoire à semi-conducteurs à un deuxième dispositif (R) de mémoire à semi-conducteurs de même type et on les évalue par le dispositif (PA) de contrôle après une lecture dans le deuxième dispositif (R) de mémoire à semi-conducteurs.

2. Procédé suivant la revendication 1,
**caractérisé**
**en ce que** l'on répète ensuite le contrôle en remplaçant le dispositif de mémoire à semi-conducteurs qui était d'abord le premier par le deuxième et le deuxième par le premier.

3. Procédé suivant l'une des revendications 1 ou 2,
**caractérisé**
**en ce que** les signaux de données sont des signaux (DQ) et le signal d'activation de données est un signal (DQS) d'une interface (DDR) suivant le standard JEDEC.

4. Procédé suivant l'une des revendications 1 à 3,
**caractérisé**
**en ce que** l'on fait fonctionner le deuxième dispositif de mémoire à semi-conducteurs pendant la transmission de données du premier au deuxième dispositif de mémoire à semi-conducteurs dans un mode de test et on diminue dans le mode de test la fenêtre de temps permise pour des accès en écriture.

5. Procédé suivant l'une des revendications 1 à 4,
**caractérisé**
**en ce que** l'on fait fonctionner l'un des deux dispositifs de mémoire à semi-conducteurs pendant la transmission de données du premier au deuxième dispositif de mémoire à semi-conducteurs dans un mode de test et on retarde le signal d'activation de données dans le mode de test.

6. Procédé suivant l'une des revendications 1 à 5,
**caractérisé**
**en ce que** l'on prévoit dans la liaison entre les bornes - activation de données du premier et du deuxième dispositifs de mémoire à semi-conducteurs un dispositif (5) de temporisation d'un premier type qui retarde le signal - activation de données du quart de la durée d'une période du signal - activation de données.

7. Procédé suivant l'une des revendications 1 à 5,
**caractérisé**
**en ce que** l'on prévoit dans la liaison entre les bornes ― activation de données du premier et du deuxième dispositifs de mémoire à semi-conducteurs un dispositif de temporisation d'un deuxième type et le dispositif de temporisation du signal - activation de données retarde la durée de toute une période du signal - activation de données et
**en ce que** l'on prévoit dans la liaison entre des bornes - données correspondantes du premier et du deuxième dispositifs de mémoire à semi-conducteurs, respectivement, des dispositifs de temporisation d'un troisième type qui retardent le signal - données correspondant de 3/4 de la durée de la période du signal - activation de données.

8. procédé suivant l'une des revendications 1 à 5,
**caractérisé**
**en ce que** l'on prévoit dans la liaison entre les bornes - activation de données du premier et du deuxième dispositifs de mémoire à semi-conducteurs un dispositif de temporisation d'un quatrième type et ce dispositif de temporisation retarde le signal - activation de données de la moitié de la durée d'une période du signal - activation de données,
**en ce que** les liaisons entre des bornes - données correspondantes du premier et du deuxième dispositifs de mémoire à semi-conducteurs ont, respectivement, des dispositifs de temporisation du premier type qui retardent le signal de données correspondant du quart de la durée de la période du signal - activation de données et
**en ce que** les deux dispositifs de mémoire à semi-conducteurs reçoivent des signaux d'horloge inversés les uns par rapport aux autres.

9. Procédé suivant l'une des revendications 1 à 8,
**caractérisé**
**en ce qu'**il est prévu comme dispositif de mémoire à semi-conducteurs des DRAM-DDR ou des dispositifs qui comportent des DRAM-DDR.

10. Dispositif pour un premier dispositif (P) de mémoire à semi-conducteurs comprenant
- une borne - activation de données bidirectionnelle pour un signal - activation de données (DQS) et
- au moins une borne - données bidirectionnelle pour des signaux (DQ) de données
sur un dispositif (PA) de contrôle qui peut produire au moins des signaux d'activation de données et des signaux de données et transmettre et évaluer des signaux de données,
**caractérisé par**
un dispositif (SV) de commutation qui relie les bornes ― courant de données et les bornes - données du premier et d'un deuxième dispositifs (R) de mémoire à semi-conducteurs, respectivement, soit au dispositif (PA) de contrôle, soit par, respectivement, une liaison avec la borne correspondante de l'autre dispositif de mémoire à semi-conducteurs.

11. Dispositif suivant la revendication 10,
**caractérisé par**
une interface DDR suivant le standard JEDEC se trouvant sur le dispositif de mémoire à semi-conducteurs.

12. Dispositif suivant l'une des revendications 10 ou 11,
**caractérisé par**
un dispositif (V) de temporisation d'un premier type dans la liaison comprise entre les bornes ― activation de données du premier et du deuxième dispositifs de mémoire à semi-conducteurs qui retarde le signal - activation de données d'un quart de la durée d'une période du signal - activation de données.

13. Dispositif suivant l'une des revendications 10 ou 11,
**caractérisé par**
un dispositif de temporisation d'un deuxième type dans la liaison entre les bornes - activation de données du premier et du deuxième dispositifs de mémoire à semi-conducteurs qui retarde le signal - activation de données de la durée de toute une période du signal - activation de données et
des dispositifs de temporisation du troisième type dans les liaisons entre des bornes ― données correspondantes du premier et du deuxième dispositifs de mémoire à semi-conducteurs qui retardent le signal de données correspondant de 3/4 de la durée de la période du signal - activation de données.

14. procédé suivant l'une des revendications 10 ou 11,
**caractérisé par**
un dispositif de temporisation d'un quatrième type dans la liaison entre les bornes - activation de données du premier et du deuxième dispositifs de mémoire à semi conducteurs qui retarde le signal - activation de données de la moitié de la durée d'une période du signal - activation de données, et
des dispositifs de temporisation du premier type dans les liaisons entre des bornes - données correspondantes du premier et du deuxième dispositifs de mémoire à semi-conducteurs qui retardent le signal de données correspondant d'un quart de la durée de la période du signal - activation de données.

15. Dispositif suivant l'une des revendications 10 à 14,
**caractérisé par**
des DRAM-DDR comme dispositif de mémoire à semi-conducteurs ou comme partie d'un dispositif de mémoire à semi-conducteurs.

16. Dispositif suivant l'une des revendications 10 à 15,
**caractérisé par**
un dispositif (PA) de contrôle conçu pour des dispositifs de mémoire à semi-conducteurs habituels sans bornes - activation de données.
